# EUROPEAN PATENT SPECIFICATION

(11) **EP 3 035 398 B1**
(45) Date of publication and mention of the grant of the patent: **13.05.2020**
(21) Application number: 14836207.2
(22) Date of filing: 18.02.2014
(51) Int. Cl.: H04N 1/04, H03K 17/96, G06F 3/041

(54) **SINGLE-ELECTRODE TOUCH SENSOR AND PREPARATION METHOD THEREFOR**
EINZELELEKTRODEN-BERÜHRUNGSSENSOR UND HERSTELLUNGSVERFAHREN DAFÜR
CAPTEUR TACTILE À ÉLECTRODE UNIQUE ET PROCÉDÉ DE PRÉPARATION POUR CELUI-CI

(30) Priority: 12.08.2013 CN 201310349759
(43) Date of publication of application: 22.06.2016
(73) Proprietor: Beijing Institute of Nanoenergy and Nanosystems, Beijing 100083 (CN)
(72) Inventor: WANG, Zhonglin, Beijing 100190 (CN); YANG, Ya, Beijing 100190 (CN); ZHANG, Hulin, Beijing 100190 (CN)
(74) Representative: Studio Torta S.p.A.
(86) International application number: PCT/CN2014/072191
(87) International publication number: WO 2015/021761

(56) References cited:
- CN-A- 102 683 573
- CN-A- 103 023 371
- CN-U- 202 815 751
- US-A1- 2011 234 557
- Anonymous: "ELM - Simple Touch Sensor", , 11 November 2007 (2007-11-11), XP055367212, Retrieved from the Internet: URL:http://elm-chan.org/works/capsens/repo rt_e.html [retrieved on 2017-04-25]
- KOICHI, KURITA ET AL.: 'A New Technique for Touch Sensing Based on Measurement of Current Generated by Electrostatic Induction' SENSORS AND ACTUATORS A: PHYSICAL vol. 170, no. 1 AND, 13 June 2011, pages 66 - 71, XP028273439
- YANG, YA ET AL.: 'Single-Electrode-Based Sliding Triboelectric Nanogenerator for Self-Powered Displacement Vector Sensor System' ACS NANO. vol. 7, no. 8, 24 July 2013, pages 7342 - 7351, XP055184239

## Description

### TECHNICAL FIELD

Embodiments of the present invention relates to a touch sensor and manufacturing method thereof, and specifically, to a single-electrode touch sensor and manufacturing method thereof.

### BACKGROUND

Existing triboelectric generators are based on mutual contact and separation of two different triboelectric materials. However, all known friction generators are based on depositing a conductive metal on a surface of a triboelectric film material to output electric energy. Such a manufacturing method leads to an increased production cost. Meanwhile, it is difficult to manufacture an electrode on some frictional materials, such as skin, air, and such restrictions greatly hamper the development of triboelectric generators.

A touch sensor converts a signal of a touch on a device into a resistance or a voltage that is in linear or an arbitrary relation with the signal and outputs the resistance or voltage, so as to realize a detection of the touch. It has a wide application prospect in fields of robotics, man-machine interfaces and security systems. Existing touch sensors are mainly based on variations of piezoresistance and capacitance, and an external power supply for these sensors is essential for normal operation of these sensors. It is hard for a touch sensor depending on an external energy supply to be widely used in energy crisis in the future, such that the key for a long-term and stable operation of these devices is to provide a self-driven touch sensor. A touch sensor manufactured based on a triboelectric generator can not only record and monitor touches in real-time, but also output electricity at the same time to power other devices.

### SUMMARY

An object of this disclosure is to provide a self-driven touch sensor, to overcome technical disadvantages of existing tracking systems.

To achieve the above object, a single-electrode touch sensor is provided according to claim 1.

According to an aspect of the present disclosure, a single-electrode touch sensor comprises: a touch layer; a sensing electrode layer, one end thereof being electrically connected with an equipotential source; and a signal monitoring member, wherein the sensing electrode layer is adhered to a lower surface of the touch layer, and the sensing electrode layer is electrically connected with the signal monitoring member.

Preferably, the touch layer is a single layer of thin sheet or thin film having a thickness from 100 nm to 1 mm.

Preferably, the thickness is from 500 nm to 800 µm.

Preferably, a material of the touch layer is selected from polymethyl methacrylate, polyvinyl alcohol, polyester, polyisobutylene, elastic sponge made from polyurethane, polyethylene glycol terephthalate, polyvinyl butyral, polychloroprene, natural rubber, polyacrylonitrile, biphenol polycarbonate, polyetherchloride, polyvinylidene chloride, polystyrene, polyethylene, polypropylene, polyimide, polyvinyl chloride, polydimethylsiloxane, and polytetrafluoroethylene.

Preferably, an upper surface of the touch layer is provided completely or partially with a micro-nano structure.

Preferably, the micro-nano structure is selected from nanowires, nanoparticles, nanorods, nanotubes, nanoflowers, and an array thereof.

Preferably, the micro-nano structure is an array consisting of linear, cubic or rectangular pyramid units, and a size of each of the units is from 10 nm to 50 µm.

Preferably, a material of the sensing electrode layer is selected from a metal, an alloy, a conductive oxide, and an organic conductor.

Preferably, the metal is gold, silver, platinum, aluminum, nickel, copper, titanium, chromium, or selenium; the alloy is selected from alloys formed from one or more of gold, silver, platinum, aluminum, nickel, copper, titanium, chromium, or selenium; the conductive oxide is Indium tin oxide (ITO); and the organic conductor is polypyrrole, polyphenylene sulfide, polyphthalocyanine based compound, polyaniline and/or polythiophene.

Preferably, the sensing electrode layer is in a shape of a plate, a sheet or a thin film, and a thickness of the thin film is from 10 nm to 5 mm.

Preferably, the sensing electrode layer is consisted of a plurality of discrete electrode units adhered to the lower surface of the touch layer; and each electrode unit is electrically connected with the signal sensing member.

Preferably, each of the electrode units is in a regular or irregular shape, and sizes and shapes of electrode units are the same or not the same.

Preferably, the signal monitoring member comprises a plurality of signal sensing units, which are the same or not the same.

Preferably, the touch layer is consisted of a plurality of touch units, and the discrete electrode units are adhered to lower surfaces of the touch units.

Preferably, the touch units are discrete or partially connected together to be arranged in a certain pattern, and the touch units are the same or not the same.

Preferably, size and shape of each touch unit are substantially the same as those of each electrode unit, and each electrode unit is adhered to the lower surface of one corresponding touch unit.

Preferably, the touch sensor further comprises an isolation layer for filling a clearance between adjacent electrode units and a clearance between adjacent touch units.

Preferably, the isolation layer is made of a material having a neutral triboelectric property.

Preferably, the touch layer and the sensing electrode layer are made of a hard material or a flexible material.

Preferably, the equipotential source is provided by grounding or an external compensation circuit.

Preferably, an electrical connection between the sensing electrode layer and the equipotential source is provided by the signal monitoring member or a load resistor.

Preferably, a resistance value of the load resistor is from 1 MΩ to 200 MΩ.

Preferably, the touch sensor comprises more than two load resistors, and resistance values of the load resistors are the same or not the same.

Embodiments of the invention also provide a touch pen for using with the forementioned touch sensor. The touch pen comprises a contact point for contacting the touch layer, and a material of the contact point having a different triboelectric property from a material of the touch layer.

Preferably, the material of the contact point is an isolator, a semiconductor, or a conductor.

Preferably, the isolator is polymethyl methacrylate, polyvinyl alcohol, polyester, or polyisobutylene.

Preferably, a size of contact surface between the contact point and the touch layer is larger than or substantially equal to a size of a region where the electrode unit in the sensing electrode layer is adhered to the touch layer.

Embodiments of the invention further provide a method for manufacturing the forementioned touch sensor. The method comprises steps of:
(1) providing a touch layer;
(2) providing a sensing electrode layer and connecting the sensing electrode layer to one input end of a signal monitoring member;
(3) connecting another input end of the signal monitoring member to an equipotential source; and
(4) adhering the touch layer to an upper surface of the sensing electrode layer, such that the touch layer and the sensing electrode layer tightly contact with each other.

Preferably, the step (2) comprises arranging a plurality of electrode units in a pattern and electrically connecting each of the electrode units with the signal monitoring member.

Preferably, the sensing electrode layer of the sensor is made of a metal material; the step (2) comprises forming the sensing electrode layer on a lower surface of the touch layer through depositing, magnetron sputtering, evaporating or printing, and electrically connecting the sensing electrode layer to the one input end of the signal monitoring member; and the step (4) is omitted.

Preferably, the method further comprises, after the step (3), a step (3-1) of providing a load resistor connected between the sensing electrode layer and the equipotential source and in parallel or in series with the signal monitoring member.

As compared with prior arts, the singe-electrode touch sensor according to this disclosure has the following advantages:
1. A self-driven touch sensor based on singe-electrode triboelectric generator is provided for the first time. This sensor does not need external power supply, and touch, separation and slide between a finger or touch pen and a material of the touch layer are mainly used to trigger the triboelectric generator to output signals, so as to record and monitor touch actions in real time.
2. This touch sensor has a simple structure and is easy to be manufactured, and can be used in smart electronic equipments, such as mobile phones and tablet computers, and man-machine interfaces.

### BRIEF DESCRIPTION OF THE DRAWINGS

The above and other objects, features and advantages of the invention will become more obvious with reference to the attached drawings. Similar reference signs indicate the similar parts throughout the drawings. The drawings are not drawn to scale, so as to emphasize substantive matters of the invention. Further, although exemplary specific values are provided for various parameters, the parameters need not to be exactly equal to such values, instead, the parameters may approximately equal to corresponding values within an acceptable or tolerable range. Additionally, the directional terms such as "upper", "lower", "front", "rear", "left", "right", etc. as used in the following embodiments indicate directions shown in the attached drawings. Thus, the directional terms used herein are intended to explain and not to limit the invention.
Fig. 1 is a schematic drawing showing an exemplary structure of the touch sensor according to an embodiment of the invention;
Fig. 2 is a schematic drawing showing a working principal of the touch sensor according to the embodiment of the invention regarding a touch-and-release action;
Fig. 3 is a schematic drawing showing another exemplary structure of the touch sensor according to an embodiment of the invention;
Fig. 4 is a schematic drawing showing a working principal of the touch sensor according to the embodiment of the invention regarding a slide action;
Fig. 5 is a schematic drawing showing another exemplary structure of the touch sensor according to an embodiment of the invention;
Fig. 6 is a schematic drawing showing another exemplary structure of the touch sensor according to an embodiment of the invention;
Fig. 7 is a schematic drawing showing another exemplary structure of the touch sensor according to an embodiment of the invention;
Fig. 8 is a schematic drawing showing a working principal of the structure shown in Fig. 7 regarding a slide action;
Fig. 9 is a schematic drawing showing another exemplary structure of the touch sensor according to an embodiment of the invention;
Fig. 10 is a schematic drawing showing a response signal of a touch sensor manufactured according to embodiment II of the invention.

### DETAILED DESCRIPTION OF PREFERRED EMBODIMENTS

Embodiments of the invention will now be expressly and fully described in connection with the accompanying drawings.

Embodiments of the invention are described with reference to the accompanying drawings, which are exemplary and are not intended to limit the scope of the invention.

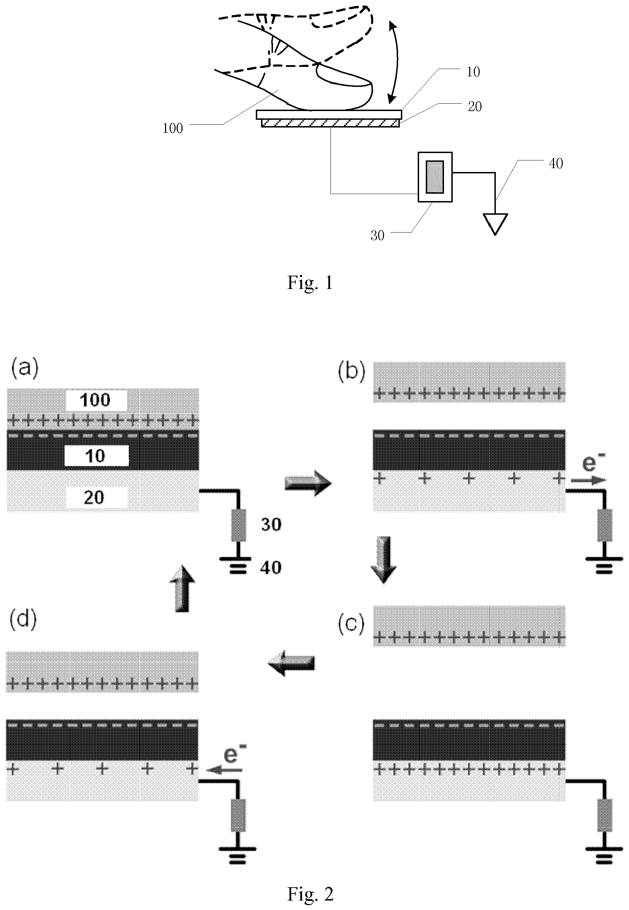

Fig. 1 shows an exemplary structure of a touch sensor according to embodiments of the invention. The touch sensor comprises: a touch layer 10; a sensing electrode layer 20, one end thereof being electrically connected with an equipotential source 40; and a signal monitoring member 30. The sensing electrode layer 20 is adhered to a lower surface of the touch layer 10, and the sensing electrode layer 20 is electrically connected with the signal monitoring member 30. For convenience, the principle of the present invention, as well as the selection principle of each component and selection range of materials, will be described in conjunction with the exemplary structure shown in Fig. 1. Such a description, however, is not limited to the embodiment shown in Fig. 1, but may be used in all technical solutions provided by of this disclosure.

An operating principle of the embodiment of the invention will be described with reference to Fig. 2, since the operating principle is only related to portions of a touch action provider and the touch layer contacting each other, only part of surfaces of the touch action provider and the touch layer at which the touch actually occurs will be described. When a provider 100, such as a finger, providing a touch action touches the touch layer 10, there is a difference in their abilities to obtain electrons due to different triboelectric properties of the skin and the touch layer 10. For example, if the skin has a relative strong ability to lose electrons, when the skin and the touch layer contact with each other, there is a slight tangential slide between microstructures of contact surfaces thereof, such that surface charges are generated by a friction therebetween, the surface of the skin has positive charges, and the surface of the touch layer 10 has negative charges (see Fig. 2-a). When the finger 100 is released, a balance between the surface charges of the skin and the touch layer 10 is destroyed, and electrons will flow to the equipotential source 40 from the sensing electrode layer 20, such that the signal monitoring member 30 can detect a corresponding electrical signal output (see Fig. 2-b). After the finger 100 is completely separated from the touch layer 10, the charges reach another balance with no flow of electrons (see Fig. 2-c). When the finger 100 is moved close to the surface of the touch layer 10 again, electrons are caused to flow from the equipotential source 40 to the sensing electrode layer 20, and a reverse current is output to the signal monitoring member 30 (see Fig. 2-d). When the finger 100 is in full contact with the touch layer 10 again, due to the balanced state of the surface charges, no electron flows in the external circuit, such that no current will be observed (see Fig. 2-a).

The triboelectric property of a material mentioned in this disclosure relates to the ability to obtain or lose electrons when the material rubs on or contacts with another material. That is, when two different materials contact with each other, one of the materials will have positive charges, the other one will have negative charges, which means the two materials have different abilities to obtain or lose electrons, and that is, they have different triboelectric properties. For example, when a nylon material contacts with an aluminum foil, the surface of the nylon material has positive charges, that it, nylon has a strong ability to loss electrons; when a Polytetrafluoroethylene (PTFE) material contacts with the aluminum foil, the surface of the PTFE material has negative charges, that is, the PTFE material has a strong ability to obtain electrons.

The following polymer materials can be used in the friction layer 10 according to embodiment of the invention, and the materials are ordered in such a manner that their abilities to obtain electrons gradually increase: polymethyl methacrylate, polyvinyl alcohol, polyester, polyisobutylene, elastic sponge made from polyurethane, polyethylene glycol terephthalate, polyvinyl butyral, polychloroprene, natural rubber, polyacrylonitrile, biphenol polycarbonate, polyetherchloride, polyvinylidene chloride, polystyrene, polyethylene, polypropylene, polyimide, polyvinyl chloride, polydimethylsiloxane, and polytetrafluoroethylene. For the sake of conciseness, not all possible materials are listed, and only a few specific polymeric materials are listed for reference. However, the listed materials shall not be considered as a limitation to the invention, because under the teaching of the invention, it is obvious for those skilled in the art to choice other similar materials based on their triboelectric properties.

Through experiments, it is found that, the greater the difference between the touch layer 10 and the touch action provider providing the touch in the ability of obtaining electrons is, the stronger an electrical signal output by a triboelectric generator is. Therefore, an optimal performance of the electrical signal can be arrived through selecting an appropriate polymer material as the touch layer 10 based on the order listed above.

In order to improve output performance of the triboelectric generator, preferably, micro-nano structures are distributed on parts or all of an upper surface of the touch layer 10 facing away from the sensing electrode layer 20, so as to increase an effective contact area between the touch layer 10 and the sensing electrode layer 20 and increase a surface charge density of the two layers. The micro-nano structures are preferably nanowires, microwires, nanoparticles, nanorods, microrods, nanotubes, microtubes, nanoflowers, or an array consisting of the aforementioned structures, in particular a nano-array formed by the nanowires, nanotubes or nanorods. The array may be an array consisting of linear, cubic, or rectangular units and formed through photolithography or the like. Sizes of each micro-nano structure is in a range from a nano magnitude to a micron magnitude, preferably, 10nm-50µm, more preferably, 50nm-10µm, and even more preferably, 100nm-5µm. It should be noted that, sizes and shapes of such micro-nano structures should not be regarded as a limitation to the scope of the invention.

Generally, the touch layer 10 is a film layer or a thin film having a thickness of 100nm-1mm, preferably, 500nm-800µm, and more preferably, 10µm-500µm. It may be a thin film available in the market, or it may be formed through a spin coating process or the like.

Generally, the touch action provider may be a finger or a touch pen, wherein skin of the finger may be in an insulation state when the skin is dry, and the skin of the finger may become a conductor in a humid condition. Nevertheless, in each state, a triboelectric property of the skin will be far different from that of a material of the touch layer 10 which is not a skin. Therefore, a touch action applied by a skin will lead to a notable signal output. If a touch pen is used, then a material of a touch point of the touch pen that contacts the touch layer should be different from the material of the touch layer 10, and preferably, the two materials should have a large difference in triboelectric properties, so as to make the sensor more sensitive. The material of the contact point of the touch pen does not need to be limited to a conductor, a semiconductor, or an insulator, because each type of the conductor, the semiconductor and the insulator includes materials having triboelectric properties far different from that of the material of the touch layer 10. The material should be varied as the material of the touch layer 10 varies. For example, the touch layer 10 is polydimethylsiloxane (PDMS), a material of the touch point of the touch pen may be polymethyl methacrylate, polyvinyl alcohol, polyester, polyisobutylene, or the like. On the basis of the action principle between the touch layer 10 and the material of the touch point of the touch pen and material selection principle provided by this disclosure, those skilled in the art can readily determine specific types of materials of the two by simple experiments. Therefore, a selection of the material of the touch point of the touch action provider shall fall within the scope of the invention.

The sensing electrode layer 20 is made from a conductive material, which may be selected from a metal, indium tin oxide, organic conductor or a doped semiconductor material. The sensing electrode layer 20 may be in a shape of a plate, a sheet or a thin film, where a thickness of the film may be in a range of 10 nm to 5 mm, preferably 50 nm to 1 mm, and more preferably 100 nm to 500 µm. Commonly used metals in the art may be: metals including gold, silver, platinum, aluminum, nickel, copper, titanium, chromium, or selenium; alloys formed from one or more of gold, silver, platinum, aluminum, nickel, copper, titanium, chromium, or selenium; conductive oxides, such as Indium tin oxide (ITO); organic conductors, usually conductive polymers, including polypyrrole, polyphenylene sulfide, polyphthalocyanine based compound, polyaniline and/or polythiophene. The sensing electrode layer 20 may be adhered to a lower surface of the touch layer 10 through a direct adhesion or a deposition process, so as to provide a close contact.

The invention is not so limited that the touch layer 10 and the sensing electrode layer 20 must be of a hard material, they can also be soft materials, because hardness of a material does not significantly affect sensing of a touch action and output of an electrical signal. If a friction surface should be maintained to be flat, they can be supported by other components. Thus, those skilled in the art can determine hardnesses of the materials of the touch layer 10 and the sensing electrode layer 20 based on practical situations.

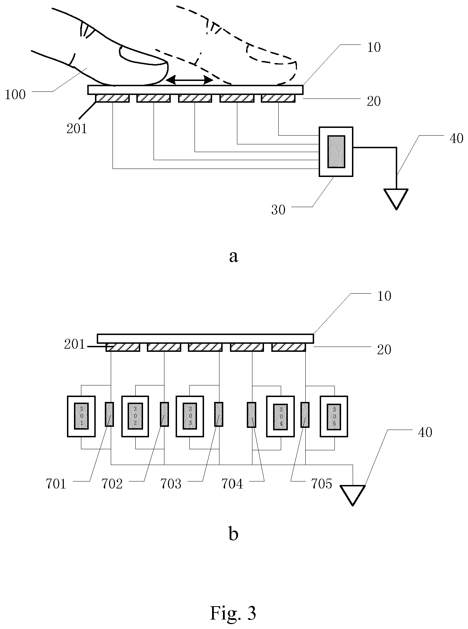

An electrical connection formed by the sensing electrode layer 20 and equipotential source 40 is the key for the sensors of according to embodiments of the invention to work properly. The equipotential source may be provided by grounding, or may be provided by an external compensation circuit. Terms "grounding" used herein means connecting to an object that can provide or receive a large amount of charges, where "ground" conventionally refers to an inductive object or earth that has a potential of zero, for example, a metal shell of a ship ,a vehicle or electronic equipment. The electrical connection may be directly realized via the signal monitoring member 30, or it can be may realized through connecting to a load resistor (see Fig. 3-b, reference numerals 701, 702, ...and 705 are load resistors), that is, the sensing electrode layer 20 is electrically connected to the equipotential source 40 via the load resistors, and the signal monitoring member 30, which needs to be powered or which performs signal detection, detects an electrical signal through being connected in serial or in parallel with the load resistor. Resistance values of the load resistor and the signal monitoring member 30 have a great impact on an output voltage. If the resistance value is large, a voltage distributed on the load and the signal monitoring member 30 is increased. Generally, the resistance values are selected to be within a range of 1MΩ -200MΩ, and preferably, 10MΩ -100MΩ.

Fig. 3-a shows another exemplary structure of a touch sensor according to embodiments of the invention. The touch sensor comprises: a sensing electrode layer 20, one end thereof being electrically connected with an equipotential source 40; and a signal monitoring member 30. The sensing electrode layer 20 consists of a plurality of discrete electrode units 201 adhered to a lower surface of the touch layer 10, and each electrode unit 201 is electrically connected with the signal monitoring member 30. Component selecting principle is the same as that of the embodiment shown in Fig. 1, which will not be repeated herein.

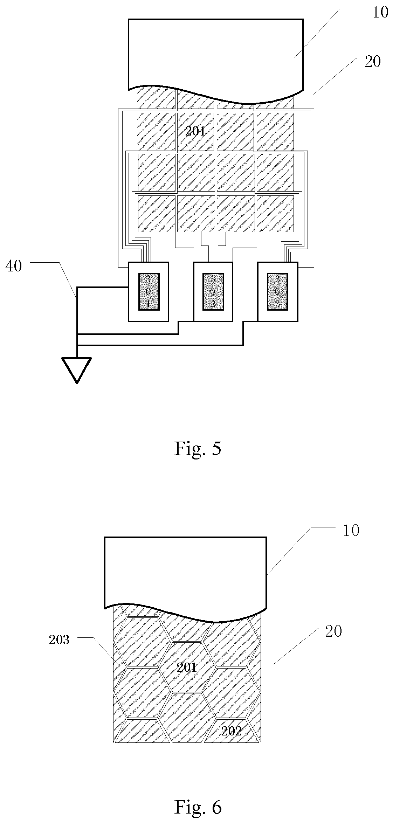

Material and thickness of the electrode unit 201 are the same as those of the aforementioned sensing electrodes 20, and preferably, the electrode unit 201 is a thin film and formed on the lower surface of the touch layer 10 through a deposition process. Each electrode unit 201 may have a regular pattern, or an irregular pattern, which may be selected based on practical requirement. Preferably, the electrode unit 201 has a regular pattern, especially a centrosymmetric shape, to facilitate an overall layout design, and the shape may be, for example, a triangle, a square, a diamond, a hexagon, an octagon, or other regular polygons, or it may be a circle. Figs. 5 and 6 are layout designs, in which the electrode units 201 are a square and a hexagon, respectively. In each of the two layouts, the entire lower surface of the touch layer 10 is covered by electrode unit 201 completely, and the purpose is to sense touch action on the entire touch layer 10. To this end, supplementary electrode units having other shapes, for example, trapezoidal electrode units 202 and triangular electrode units 203, may be provided at corners of the touch layer. Of course, there may be a case in which only a portion of the lower surface of the touch layer 10 is provided with electrode units 201, so as to sense a certain position of the touch layer, on which touch action should be detected. Sizes and shapes of the electrode units may be the same or different, and may be adjusted depending on requirement of a certain layout.

A size of a portion where an electrode unit 201 joints with the touch layer 10 and a distance between adjacent electrode units 201 are related to precision of a touch sensor. For touch layers 10 having the same area, the one having more electrode units 201 will be more precise in locating the position of touch. In the other hand, the larger an area of an electrode unit 201 is, the stronger an output electrical signal is. Further, a size of an electrode unit 201 should also match a size of a region of the touch layer 10 where the touch action provider, such as a finger or a touch pen, applies a touch action. Preferably, the sizes of the two are comparable, and more preferably, the sizes are close to each other, or a size of a region of the touch layer 10 where the touch action provider applies a touch action is larger than or substantially equal to a size of a region where the electrode unit 201 is adhered to the touch layer 10.

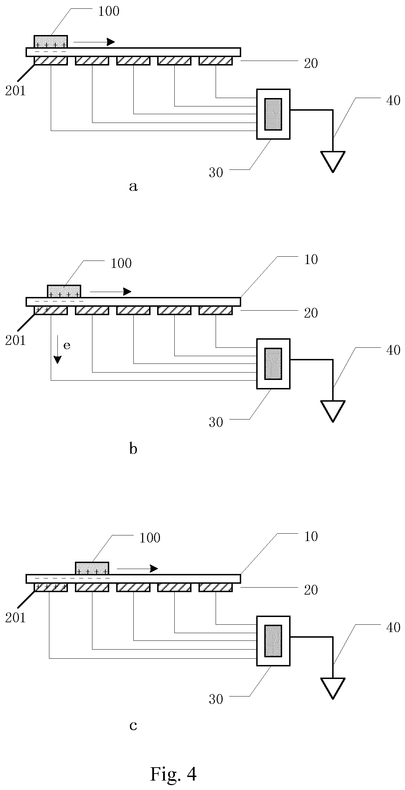

This embodiment not only can generate signals upon touch actions of a contact-and-separate type, which is the same as the embodiment shown in Fig. 1, but also can detect touch actions of a sliding type. Its operating principle is shown in Fig. 4. When a touch action provider 100 contacts the touch layer 10, positive charges are generated at the lower surface of the touch action provider 100 and an equal amount of negative charges are generated at a corresponding portion of the touch layer 10 due to the effect of contact and friction (see Fig. 4-a); When the touch action provider 100 slides on the upper surface of the touch layer 10 in the direction indicated by an arrow, a mismatch of surface charges occurs due to change of contact surface between the touch action provider and the touch player. In order to balance a potential difference generated by such a mismatch, the negative charges flow from the electrode unit 201 to the equipotential source 40, such that an electrical signal output is generated at the signal monitoring element 30. The signal monitoring element 30 can show through a locating function that there is a touch action at a certain position (see Fig. 4-b). The touch action provider 100 continues sliding in the direction indicated by the arrow and after it has completely separated from the leftmost electrode unit 201, an equal amount of positive charges are induced on the leftmost electrode unit 201 so as to balance the surface charges left on the corresponding touch layer 10. Then the touch action provider 100 and the touch layer 10 repeat the action shown in Fig. 4-a, and equal amounts of surface charges are generated through the sliding friction between the contact surfaces of the touch action provider and the touch layer (see Fig. 4-c). surface charges on the leftmost electrode unit 201 and on a portion of the touch layer 10 corresponding to the leftmost electrode unit 201, and surface charges on other portions of the touch layer 10 having no corresponding electrode unit 201 will gradually disappear under ambient conditions, and finally, the sensor restores to its original state having no friction. A weak current generated during such a restoration may be shielded as a noise and will have no effect on the normal operation of the sensor.

Fig. 3-b shows an exemplary structure, in which load resistors are connected in the touch sensor. A main configuration of this structure is the same as that shown in Fig. 3-a, except that each electrode unit 201 is electrically connected to the equipotential source 40 via a load resistor, and a plurality of signal monitoring members (reference numerals 301, 302, 303, 304 and 305) are connected in parallel with the load resistors respectively. In such a manner, intensity of an output signal may be adjusted through adjusting the resistance values of the load resistors. When two or more load resistors are included, these load resistors may be the same as or different from each other. An increase in the resistance values of the load resistors leads to an increase in output voltage, so that a user may adjust the load resistors connected with different electrode units 201 based on practical requirement, such that output signals meet the requirement.

Fig. 5 is another exemplary structure of the touch sensor according to embodiments of the invention. The touch sensor comprises: a sensing electrode layer 20, one end thereof being electrically connected with an equipotential source 40; and a signal monitoring member 30. The sensing electrode layer 20 consists of a plurality of discrete electrode units 201 adhered to a lower surface of the touch layer 10, and each electrode unit 201 is electrically connected with the signal monitoring member 30. The signal monitoring member 30 comprises a plurality of signal monitoring units represented by a first signal monitoring unit 301, a second signal monitoring unit 302, and a third signal monitoring unit 303 shown in the drawings. Types of these signal monitoring units may be the same, but connected to different electrode units 201. Such a technical theme is adapted for a situation where a signal monitoring unit does not have enough monitoring channels. When the signal monitoring unit has enough monitoring channels, each signal monitoring unit may be connected to all the electrode units 201, while the types of these signal monitoring units may be different. For example, the first signal monitoring unit 301 may be used to monitor current, the second first signal monitoring unit 302 may be used to monitor voltage, and the third first signal monitoring unit 303 may be used to monitor current density, or the like. With this technical theme, various kinds of signals may be obtained at the same time, so that a touch action can be analyzed through different ways, such that signals of the sensor can be more precise. A selection of the signal monitoring unit is conventional in this technical field and is not a key point of this disclosure, which will not be described in detail.

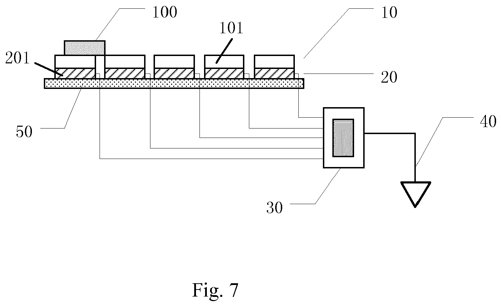

FIG. 7 shows another exemplary structure of the touch sensor according to embodiments of the invention. The touch sensor comprises: a sensing electrode layer 20, one end thereof being electrically connected with an equipotential source 40; and a signal monitoring member 30. The touch layer 10 consists of a plurality of touch units 101, the sensing electrode layer 20 consists of a plurality of discrete electrode units 201 adhered to lower surfaces of the touch units 101, and each electrode unit 201 is electrically connected with the signal monitoring member 30.

The touch units 101 may be discrete or partially connected together so as to be arranged in a certain pattern. Meanwhile, the touch units may be the same as or different from each other. For example, in a region where a high sensitivity is required, the touch unit may be formed of a material have a micro-nano structure in surface thereof or a material having a triboelectric property that is far different from that of a material of the touch action provider; in a region where a high locating precision is required, small sized touch units may be utilized to increased distribution density of the touch units. Under the guidance of these principles, those skilled in the art can adjust the material, the sizes and the shape of the touch unit 101 according to practical requirement, so as to provide a proper layout.

Shape and sizes of the electrode unit 201 shown in FIG. 7 is substantially the same as those of the touch unit, and the lower surface of each touch unit 101 is provided with a corresponding electrode unit 201. However, such a configuration is just an exemplary embodiment and is not so defined in practical applications. The lower surface of each touch unit 101 may be provided with one or more electrode units 201; the shape of the electrode unit 201 may be same as or totally different from that of touch unit 101.

A support member 50 located at the lower surface of the sensing electrode layer 20 may be a part of the sensor itself or may be provided externally, and therefore it does not have to be part of the sensor. Preferably, the support member 50 is made of an insulating material, which may be a hard material or a flexible material, as long as the material can provide a certain mechanical strength to support the touch units 101 and the electrode units 201.

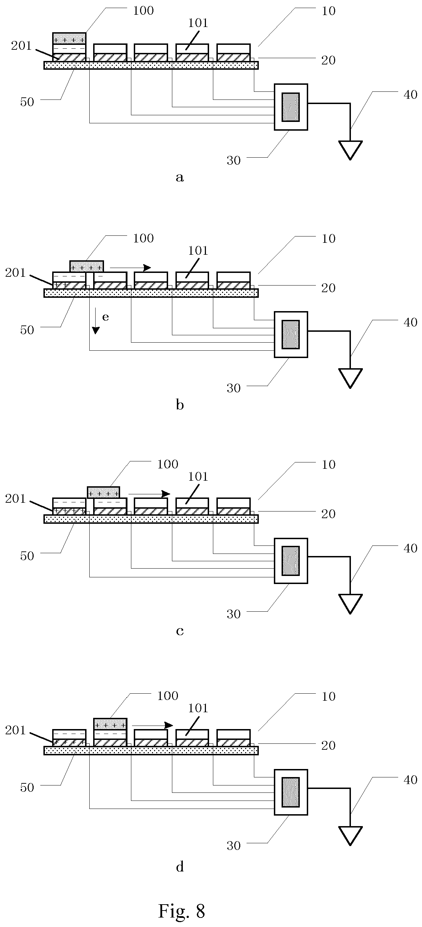

An operating principle of the touch sensor having such a configuration is shown in Fig. 8. When a touch action provider 100 contacts a touch unit 101, positive charges are generated at a lower surface of the touch action provider 100 and an equal amount of negative charges are generated at an upper surface of the touch unit 101 due to the effect of contact and friction (see Fig. 8-a). When the touch action provider 100 slides in the direction indicated by an arrow, a mismatch of surface charges occurs due to change of contact surface area between the touch action provider and the touch player. In order to balance a potential difference generated by such a mismatch, the negative charges flow from the electrode unit 201 to the equipotential source 40, such that an electrical signal output is generated at the signal monitoring element 30. The signal monitoring element 30 can show through a locating function that there is a touch action at the position of the first touch unit 101 (see Fig. 8-b). The touch action provider 100 continues sliding in the direction indicated by the arrow and after it has completely separated from the leftmost touch unit 101, an equal amount of positive charges are induced on the electrode unit 201 corresponding to the leftmost touch unit, so as to balance the surface charges left on the touch unit 101. A sliding friction between the touch action provider 100 and a second touch unit 101 causes an upper surface of the second touch unit 101 charged gradually with negative charges (see Fig. 8-c). After the touch action provider 100 has contacted with the second touch unit 101 completely, surface charges on the upper surface of the second touch unit 101 reaches a maximum amount (see Fig. 8-d). When the touch action provider 100 continues sliding in the direction indicated by the arrow, actions in steps a to d are repeated.

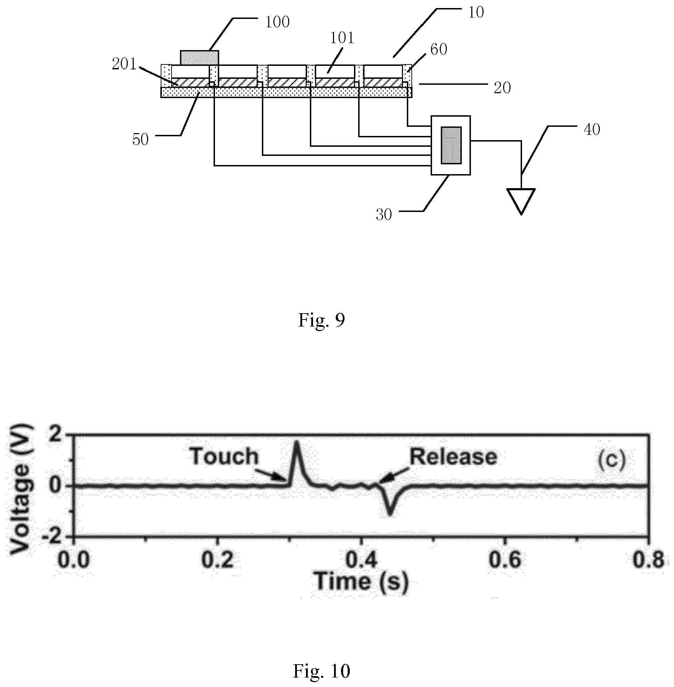

Embodiment shown in Fig. 9 is similar to that shown in FIG. 7, the only difference therebetween lies in that isolation layers 60 are filled within clearances between adjacent electrode units 201 and clearances between adjacent touch units 101. The isolation layers 60 are to keep a touch surface smooth, and to increase mechanical strength and life of a sensor. Preferably, the isolation layers 60 are made of a material having a neutral triboelectric property, such as wood plates, or organic glass.

The touch sensors according to embodiments of the invention can not only detect and locate a touch action, but also sensing a pressure applied by the touch action. In an example, response of output electrical signals of a 4×4 sensor to touch actions is studied, wherein the sensor is configured in accordance with the configuration shown in Fig. 3, the touch layer 10 is made of polydimethylsilicone, and the sensing electrode layer 20 is made of an indium tin oxide (ITO) film. A result of this study shows that, when different positions on the touch layer 10 corresponding to different electrode units 201 are pressed, the signal monitoring member 30 shows that electrical signals will be generated at corresponding positions. And as strength of press increases, output voltage increases. When the sensor is fixed on a plastic cylinder, sensing property of the sensor does not change. When a finger presses on different positions of the sensor with different pressure, output signals are remarkably different from each other.

The touch sensor according to embodiments of the invention may be manufactured through the following steps of:
(1) providing a touch layer 10;
(2) providing a sensing electrode layer 20 and connecting the sensing electrode layer to one input end of a signal monitoring member 30;
(3) connecting another input end of the signal monitoring member 30 to an equipotential source 40; and
(4) adhering the touch layer 10 to an upper surface of the sensing electrode layer 20 such that the touch layer and the sensing electrode layer tightly contact with each other.

When a touch action provider, such as a finger, contacts the touch layer 10, the sensor outputs a signal due to different triboelectric properties of skin and the material of the touch layer 10. The signal monitoring member 30 samples and analyzes the signal, such that we may know the position where the touch action occurs.

If the sensing electrode layer 20 is consisted of a plurality of electrode units 201, before performing step (3), the plurality of electrode units 201 should be arranged in a required pattern first, and each of the electrode units 201 is electrically connected with the signal monitoring member 30 in the above step (2).

If a resistance value of the signal monitoring member 30 is small, then after step (3), an additional step (3-1) of providing a load resistor connected between the sensing electrode layer and the equipotential source and in parallel with the signal monitoring member is performed.

If the sensing electrode layer 20 of the sensor is made of a metal material, preferably, the above step (2) comprises forming the sensing electrode layer 20 on a lower surface of the touch layer 10 through depositing, magnetron sputtering, evaporating or printing, and electrically connecting the sensing electrode layer 20 to the one input end of the signal monitoring member 30. In this embodiment, the step (4) may be omitted.

### Example 1: manufacturing a touch sensor having a single sensing electrode

Through a cutting process, an aluminum foil having sizes of 10 cm in length × 10 cm in width × 25 µm in thickness is provided as an electrode layer. A layer of polymer (e.g., polydimethylsiloxane (PDMS)) used as a triboelectric material is coated on the electrode layer through a spin coating process. The aluminum foil is connected to one end of a resistor by a copper conducting wire, and the other end of the resistor is grounded. The copper conducting wire is also connected with a voltage meter. If, when a finger touches the polymer (PDMS) layer, the voltage meter indicates an output signal, then this sensor can convert mechanical energy into electrical energy and thereby generating electricity. When the finger is removed from the polymer (PDMS) layer, an inverse electrical signal may be observed.

### Example 2: manufacturing a touch sensor having a multiple sensing electrodes

Through a laser cutting process, a piece of organic glass having sizes of 10 cm in length × 10 cm in width × 1.59 mm in thickness is provided as a support member. An array of 16 transparent electrode units (for example, the electrode units are made of ITO), each having sizes of 1 cm in length × 1 cm in width, is formed on the support member through magnetron sputtering, such that a sensing electrode layer is formed. Each of the 16 transparent electrode units are connected to one end of a corresponding resistor of 16 resistors by a corresponding copper conducting wire of 16 copper conducting wires respectively, and the other end of each resistor is grounded. Meanwhile, each resistor is connected in parallel with a voltage testing device. A layer of polymer, such as polydimethylsiloxane (PDMS), is formed on the sensing electrode layer to completely cover the entire electrode array. When a finger touches a surface of the polymer (PDMS) layer on the electrode units, the sensor output an electrical signal(s) due to different triboelectric properties of skin and the polymer layer. Through sampling these signals, the sensor may detect position and pressure of the touch. This system utilizes a triboelectric generator as the sensor to be triggered, such that no external power supply is needed, energy can be efficiently saved, and this system may operate stably for a long time. Fig. 10 shows a voltage signal output by the touch sensor when a finger touches and separates from the touch sensor.

Described above are preferable embodiments of the invention, which are not intended to limit the invention in any form. Under the teaching of the above disclosed method and technical themes, those skilled in the art can make various changes and modifications to the embodiments of the invention or provide equivalent embodiments without departing from the concept of the invention.

## Claims

1. A single-electrode touch sensor comprising:
a touch layer (10);
a sensing electrode layer (20) adhered to a lower surface of the touch layer (10) and electrically connected to an equipotential source (40); and
a signal monitoring member (30) electrically connected with the sensing electrode layer (20); and
a touch-action provider (100) having a contact portion,
the touch sensor being **characterized in that** the contact portion of the touch-action provider (100) is of a material having a triboelectric property different from that of the material of the touch layer (10),
and **in that**:
in a first operating condition, when the contact portion of the touch-action provider (100) and the touch layer (10) are in contact with each other, surface charges are generated by a friction caused by a slight tangential slide between microstructures of said contact portion and the touch layer (10), so that first charges having a first sign develop at the contact portion, and second charges having a second sign opposite to the first sign develop at the touch layer's surface; and
in a second operating condition, following the first operating condition, when said contact portion is released from the touch layer (10), a balance between the first charges and the second charges is destroyed, and electrons are free to flow from the sensing electrode layer (20) to the equipotential source (40), the signal monitoring member (30) being configured to detect a corresponding electrical signal output.

2. The touch sensor according to claim 1, **characterized in that** an upper surface of the touch layer is provided completely or partially with a micro-nano structure.

3. The touch sensor according to claim 1 or 2, **characterized in that** the sensing electrode layer (20) is consisted of a plurality of discrete electrode units (201) adhered to the lower surface of the touch layer (10); and each electrode unit (201) is electrically connected with the signal sensing member (30).

4. The touch sensor according to claim 3, **characterized in that** the signal monitoring member (30) comprises a plurality of signal sensing units (301, 302, 303, 304, 305), and each electrode unit is connected to one corresponding signal monitoring unit of the plurality of signal sensing units (301, 302, 303, 304, 305).

5. The touch sensor according to claim 3, **characterized in that** the touch layer (10) is consisted of a plurality of touch units (101), and the discrete electrode units (201) are adhered to lower surfaces of the touch units (101).

6. The touch sensor according to claim 5, **characterized in that** the touch units (101) are discrete or partially connected together to be arranged into a pattern.

7. The touch sensor according to claim 6, **characterized in that** size and shape of each touch unit (101) are substantially the same as those of each electrode unit (201), and each electrode unit (201) is adhered to the lower surface of one corresponding touch unit (101).

8. The touch sensor according to claim 5, **characterized in that** the touch sensor further comprises an isolation layer (60) for filling a clearance between adjacent electrode units (201) and a clearance between adjacent touch units (101).

9. The touch sensor according to claim 1, **characterized in that** an electrical connection between the sensing electrode layer (20) and the equipotential source (40) is provided by the signal monitoring member (30) or a load resistor (701, 702, 703, 704, 705).

10. The touch sensor according to claim 3, **characterized in that** the size of contact surface between the contact portion and the touch layer (10) is larger than or substantially equal to a size of the region where one electrode unit (201) of the sensing electrode layer (20) is adhered to the touch layer (10).

## Patentansprüche

1. Einzelelektroden-Berührungssensor, umfassend:
eine Berührungsschicht (10);
eine Messelektrodenschicht (20), die an einer unteren Oberfläche der Berührungsschicht (10) angehaftet ist und elektrisch mit einer Äquipotentialquelle (40) verbunden ist; und
ein Signalüberwachungselement (30), das elektrisch mit der Messelektrodenschicht (20) verbunden ist; und
einen Berührungsaktionserbringer (100), der einen Kontaktabschnitt aufweist,
wobei der Berührungssensor **dadurch gekennzeichnet ist, dass** der Kontaktabschnitt des Berührungsaktionserbringers (100) aus einem Material besteht, das eine triboelektrische Eigenschaft aufweist, die sich von der des Materials der Berührungsschicht (10) unterscheidet,
und dadurch, dass:
in einem ersten Betriebszustand, wenn der Kontaktabschnitt des Berührungsaktionserbringers (100) und die Berührungsschicht (10) in Kontakt miteinander sind, durch eine Reibung, die durch eine leichte tangentiale Verschiebung zwischen Mikrostrukturen des Kontaktabschnitts und der Berührungsschicht (10) verursacht wird, Oberflächenladungen so erzeugt werden, dass erste Ladungen, die ein erstes Vorzeichen aufweisen, an dem Kontaktabschnitt entstehen, und zweite Ladungen, die ein zweites Vorzeichen aufweisen, das entgegengesetzt zu dem ersten Vorzeichen ist, an der Oberfläche der Berührungsschicht entstehen; und
in einem zweiten Betriebszustand, der auf den ersten Betriebszustand folgt, wenn der Kontaktabschnitt von der Berührungsschicht (10) gelöst wird, ein Gleichgewicht zwischen den ersten Ladungen und den zweiten Ladungen zerstört wird, und Elektronen frei von der Messelektrodenschicht (20) zu der Äquipotentialquelle (40) fließen können, wobei das Signalüberwachungselement (30) so ausgestaltet ist, dass es eine entsprechende Ausgabe eines elektrischen Signals erkennt.

2. Berührungssensor nach Anspruch 1, **dadurch gekennzeichnet, dass** eine obere Oberfläche der Berührungsschicht vollständig oder teilweise mit einer Mikro-Nano-Struktur versehen ist.

3. Berührungssensor nach Anspruch 1 oder 2, **dadurch gekennzeichnet, dass** die Messelektrodenschicht (20) aus einer Vielzahl von diskreten Elektrodeneinheiten (201) besteht, die an der unteren Oberfläche der Berührungsschicht (10) angehaftet sind; und jede Elektrodeneinheit (201) elektrisch mit dem Signalerfassungselement (30) verbunden ist.

4. Berührungssensor nach Anspruch 3, **dadurch gekennzeichnet, dass** das Signalüberwachungselement (30) eine Vielzahl von Signalerfassungseinheiten (301, 302, 303, 304, 305) umfasst, und jede Elektrodeneinheit mit einer entsprechenden Signalüberwachungseinheit der Vielzahl von Signalerfassungseinheiten (301, 302, 303, 304, 305) verbunden ist.

5. Berührungssensor nach Anspruch 3, **dadurch gekennzeichnet, dass** die Berührungsschicht (10) aus einer Vielzahl von Berührungseinheiten (101) besteht, und die diskreten Elektrodeneinheiten (201) an unteren Oberflächen der Berührungseinheiten (101) angehaftet sind.

6. Berührungssensor nach Anspruch 5, **dadurch gekennzeichnet, dass** die Berührungseinheiten (101) diskret oder so teilweise miteinander verbunden sind, dass sie in einem Muster angeordnet sind.

7. Berührungssensor nach Anspruch 6, **dadurch gekennzeichnet, dass** Größe und Form jeder Berührungseinheit (101) im Wesentlichen die gleichen sind wie die jeder Elektrodeneinheit (201), und jede Elektrodeneinheit (201) an der unteren Oberfläche einer entsprechenden Berührungseinheit (101) angehaftet ist.

8. Berührungssensor nach Anspruch 5, **dadurch gekennzeichnet, dass** der Berührungssensor ferner eine Isolationsschicht (60) zum Ausfüllen eines Zwischenraums zwischen benachbarten Elektrodeneinheiten (201) und eines Zwischenraums zwischen benachbarten Berührungseinheiten (101) umfasst.

9. Berührungssensor nach Anspruch 1, **dadurch gekennzeichnet, dass** eine elektrische Verbindung zwischen der Messelektrodenschicht (20) und der Äquipotentialquelle (40) mittels des Signalüberwachungselements (30) oder eines Lastwiderstands (701, 702, 703, 704, 705) bereitgestellt ist.

10. Berührungssensor nach Anspruch 3, **dadurch gekennzeichnet, dass** die Größe der Kontaktoberfläche zwischen dem Kontaktabschnitt und der Berührungsschicht (10) größer als oder im Wesentlichen gleich einer Größe des Bereichs ist, in dem eine Elektrodeneinheit (201) der Messelektrodenschicht (20) an der Berührungsschicht (10) angehaftet ist.

## Revendications

1. Capteur tactile à électrode unique, comprenant :
une couche tactile (10) ;
une couche d'électrode de détection (20) collée à une surface inférieure de la couche tactile (10) et connectée électriquement à une source équipotentielle (40) ; et
un élément de surveillance de signal (30) connecté électriquement à la couche d'électrode de détection (20) ; et
un fournisseur d'action tactile (100) présentant une partie de contact ;
le capteur tactile étant **caractérisé en ce que** la partie de contact du fournisseur d'action tactile (100) est constituée d'un matériau présentant une propriété triboélectrique différente de celle du matériau de la couche tactile (10) ; et
**en ce que**
dans une première condition de fonctionnement, lorsque la partie de contact du fournisseur d'action tactile (100) et la couche tactile (10) sont en contact l'une avec l'autre, des charges superficielles sont générées par un frottement occasionné par un léger glissement tangentiel entre des microstructures de ladite partie de contact et de la couche tactile (10), de sorte que des premières charges présentant un premier signe se développent au niveau de la partie de contact, et des secondes charges présentant un second signe opposé au premier signe se développent au niveau de la surface de la couche tactile ; et
dans une seconde condition de fonctionnement, suivant la première condition de fonctionnement, lorsque ladite partie de contact est libérée de la couche tactile (10), un équilibre entre les premières charges et les secondes charges est détruit, et des électrons sont libres de circuler de la couche d'électrode de détection (20) à la source équipotentielle (40), l'élément de surveillance de signal (30) étant configuré de manière à détecter une sortie de signal électrique correspondante.

2. Capteur tactile selon la revendication 1, **caractérisé en ce qu'**une surface supérieure de la couche tactile est pourvue complètement ou partiellement d'une micro-nanostructure.

3. Capteur tactile selon la revendication 1 ou 2, **caractérisé en ce que** la couche d'électrode de détection (20) est constituée d'une pluralité d'unités d'électrode discrètes (201) collées à la surface inférieure de la couche tactile (10) ; et chaque unité d'électrode (201) est connectée électriquement à l'élément de surveillance de signal (30).

4. Capteur tactile selon la revendication 3, **caractérisé en ce que** l'élément de surveillance de signal (30) comprend une pluralité d'unités de détection de signal (301, 302, 303, 304, 305), et chaque unité d'électrode est connectée à une unité de surveillance de signal correspondante de la pluralité d'unités de détection de signal (301, 302, 303, 304, 305).

5. Capteur tactile selon la revendication 3, **caractérisé en ce que** la couche tactile (10) est constituée d'une pluralité d'unités tactiles (101), et les unités d'électrode discrètes (201) sont collées sur des surfaces inférieures des unités tactiles (101).

6. Capteur tactile selon la revendication 5, **caractérisé en ce que** les unités tactiles (101) sont discrètes ou sont partiellement reliées entre elles afin d'être agencées en un motif.

7. Capteur tactile selon la revendication 6, **caractérisé en ce qu'**une taille et une forme de chaque unité tactile (101) sont sensiblement les mêmes que celles de chaque unité d'électrode (201), et chaque unité d'électrode (201) est collée à la surface inférieure d'une unité tactile correspondante (101).

8. Capteur tactile selon la revendication 5, **caractérisé en ce que** le capteur tactile comprend en outre une couche d'isolation (60) destinée à remplir un espace entre des unités d'électrode adjacentes (201) et un espace entre des unités tactiles adjacentes (101).

9. Capteur tactile selon la revendication 1, **caractérisé en ce qu'**une connexion électrique entre la couche d'électrode de détection (20) et la source équipotentielle (40) est fournie par l'élément de surveillance de signal (30) ou par une résistance de charge (701, 702, 703, 704, 705).

10. Capteur tactile selon la revendication 3, **caractérisé en ce que** la taille de surface de contact entre la partie de contact et la couche tactile (10) est supérieure ou sensiblement égale à une taille de la région où une unité d'électrode (201) de la couche d'électrode de détection (20) est collée à la couche tactile (10).
